# EUROPÄISCHE PATENTSCHRIFT

(11) **EP 1 026 743 B1**
(45) Veröffentlichungstag und Bekanntmachung des Hinweises auf die Patenterteilung: **11.07.2007**
(21) Anmeldenummer: 00101132.9
(22) Anmeldetag: 21.01.2000
(51) Int. Cl.: H01L 25/07, H01L 25/11, H01L 23/48

(54) **Umrichter in Druckkontaktierung**
Pressure contact converter
Convertisseur à contact par pression

(30) Priorität: 01.02.1999 DE 19903875
(43) Veröffentlichungstag der Anmeldung: 09.08.2000
(73) Patentinhaber: SEMIKRON Elektronik GmbH & Co. KG, 90431 Nürnberg (DE)
(72) Erfinder: Göbl, Christian, 90441 Nürnberg (DE); Eberhard, Harald, 71334 Waiblingen (DE)

(56) Entgegenhaltungen:
- EP-A- 0 282 307
- DE-A- 4 131 200
- DE-A- 19 630 173
- DE-A- 19 651 632
- DE-C- 19 834 800
- US-A- 5 296 739
- US-A- 5 977 568

## Beschreibung

Die Erfindung beschreibt eine Leistungshalbleiterschaltungsanordnung, insbesondere in der Form von Stromrichtern der Leistungsklasse, nach dem Oberbegriff des Anspruches 1, die in ihrer Ausführung zumindest teilweise für Druckkontaktaufbauten geeignet ist. Druckkontaktverbindungen sind aus der Technologie der Herstellung von Halbleitermodulen bzw. -schaltungen als Verbindungstechnik hinlänglich bekannt.

Die Kontaktsicherheit von Druckkontaktaufbauten ist bei Dauer- oder Wechsellastbetrieb von entscheidender Bedeutung für die Funktionssicherheit der Schaltungsanordnung. Alle äußeren Anschlüsse müssen bei wechselnden thermischen und elektrischen Belastungen immer einen sicheren Kontakt zu den internen Kontaktstellen aller Anschlüsse der Schaltungsanordnung gewährleisten. Bei formschlüssigen Kontakten wird durch das Erlahmen der Druckkräfte eine Funktionsstörung des gesamten Aufbaus in realer Zeit verursacht. Zur Erzielung einer höheren Lebensdauer sind aus der Literatur zu dieser Problematik viele Bemühungen durch deren Beschreibungen bekannt. Um das Erreichen einer unbegrenzten Lebensdauer wird gerungen.

Die Technologie der Druckkontaktierung ist, bedingt durch die Erfordernisse der Hermetisierung gegenüber der Atmosphäre, wiederholt Gegenstand der beschriebenen Forschung durch Schaffen aller Voraussetzungen für eine praktizierbare Technik gewesen.

In DE 35 08 456 A1 wird ein Druckkontaktaufbau und dessen Verfahren zur Herstellung von Leistungshalbleitermodulen beschrieben. Durch justierte Verschraubungen wird die in dem Gehäuse vorhandene innere Spannkraft zum Drücken der Isolierkeramik bzw. der Leistungshalbleiter auf die Kühlfläche herangezogen. Das Nachlassen der Spannkraft des Gehäuses als Element des Druckaufbaues spricht gegen eine lange Lebensdauer der so aufgebauten Module, da hier kein weiterer Druckenergiespeicher vorgesehen ist.

In DE 41 22 428 A1 wird ein als Druckspeicher fungierendes Kissenelement in die Schaltungsanordnung eingebaut. Dieses Kissenelement liegt auf einem Brückenelement, das die schaltungsinternen Bauteile fixiert und darauf Druck ausübt. Die mechanische Stabilität des Brückenelementes wird durch eine Druckplatte oberhalb des Kissenelementes erzeugt, wobei deren Verschraubung mit dem Kühlelement einen statischen Druck aufbaut. Durch diese Dreifachkombination wird eine aufwendige, aber funktionell sehr gut arbeitende Lösung erzielt, ein Erlahmen des Kissenelementes als Druckspeicher ist im Langzeitverhalten denkbar.

DE 41 31 200 C2 stellt eine Schaltungsanordnung vor, bei der eine Andrückvorrichtung für einen Druckkontakt aus einem Brückenelement besteht, das mit entsprechenden Erhebungen und Einsenkungen ausgebildet ist und mit dem die schaltungsgerechten elektrischen Verbindungen und thermischen Kontakte der Aufbauteile nach Druckbeaufschlagung hergestellt werden. Die Andrückvorrichtung ist aus einem Kunststoff geformt, der im laufenden Betrieb einer Alterung unterliegt, was einen sehr massigen Aufbau bedingt.

In einer früheren Anmeldung, der DE 195 31 496 C1, wird ein druckgebendes Gehäuse mit gleichartig ausgebildeten Drucklippen vorgestellt, wodurch bei Beachtung der übrigen Aufbauvorschriften eine gleichartige Druckverteilung auf alle Verlustwärme erzeugenden Bauteile des Moduls gegeben ist, dabei wird jedes einzelne Bauteil federnd gedrückt. Für sehr große Flächendrücke ist eine solche Drucklippenfederung jedoch nicht geeignet. Auch hier können durch Alterung Druckminderungen durch Fließen des Kunststoffes auftreten, was eine sehr massige Ausführung erforderlich macht und die erwähnte Begrenzung auf Bereiche mit kleinerem Flächendruck begründet.

DE 196 30 173 A1 trägt den möglichen Langzeitinstabilitäten der beiden vorgenannten Veröffentlichungen dadurch Rechnung, daß Verstärkungen in dem Druckstück aus Kunststoff ausgebildet worden sind. Der Druckspeicher ist hier mittig angeordnet, um von dem Zentrum aus eine gleichmäßige Druckverteilung zu erreichen.

DE 196 51 632 A1 schlägt als druckgebendes Aufbauelement eine Dehnschraube vor, die bei den unterschliedlichen Temperaturen der Schaltungsanordnung für einen Innendruck in den technologisch festgelegten Grenzen sorgt. Diese dynamische Druckangleichung besitzt insbesondere für Schaltungsanordnungen sehr hoher Leistungen Vorteile und eine unbegrenzte Lebensdauer bezüglich eines konstanten Druckes aller Aufbauteile kann erwartet werden.

Die an 28.10.1999 offenbarte Druckschrift DE 198 34 800 C1 offenbart eine Leistungshalbleiterschalungsanordnung mit einer Isolierkeramik und Halbleiterbauelemente, wobei Anschlussverbinder (Last- und Hilfsanschlüss) auf Kontaktflächen der Isolierkeramik aufgelötet sind. Ein Druckelemente zum Andruck der Leistungshalbleiterschalungsanordnung auf einen Kühlkörper besteht aus einem Verbundwerkstoff aus einem Bimetall mit einer Kunststoffummantelung. Die Anschlussverbinder sind hierbei zwischen einem rahmenartigen Gehäuse und dem Druckelement, das als Deckel dient angeordnet.

Dieser Erfindung liegt die Aufgabe zugrunde, einen Umrichter mit einem Treiber und einer einfach zu realisierenden Schaltungsanordnung für Leistungshalbleiterbauelemente sehr hoher Packungsdichte mit hoher Zuverlässigkeit in Druckkontaktausführung mit einer Druckplatte vorzustellen, die zuverlässig eine Langzeitlebensdauer garantiert.

Diese Aufgabe wird erfindungsgemäß durch die Maßnahmen des kennzeichnenden Teiles des Anspruches 1 gelöst, bevorzugte Weiterbildungen sind in den Unteransprüchen beschrieben.

Die Grenzen der möglichen Leistungsdichte einer Leistungshalbleiterschaltungsanordnung für Stromumrichter in Druckkontaktausführung wurden und werden durch die dauerhafte und gleichförmige Funktionssicherheit der kontaktierten Leistungshalbleiterbauelemente bzw. der daraus aufgebauten Modulplättchen mit den äußeren Starkstromanschlüssen bestimmt. Der ohmsche Kontakt aller sekundären Verbindungselemente und ein guter Abtransport der im Betrieb entstehenden Verlustwärme zu Kühlelementen sind die zwingenden Voraussetzungen für eine zuverlässige Langzeitqualität in Druckkontaktausführung.

Sichere Druckkontakte verlangen in jedem Betriebszustand eine definierte und immer in vorgegebenen Grenzen gehaltene Andrückkraft zur Vermeidung von überhöhten elektrischen und thermischen Übergangswiderständen einerseits oder Druckdeformierungen andererseits. Dazu ist der Einsatz von Druckspeichern erforderlich.

Einerseits werden elektrisch sichere Kontakte an allen Kontaktstellen benötigt, es muß durch die Montageelemente folglich ein gleichmäßiger Druckaufbau erreicht werden, also eine gute Druckverteilung zu allen Druckkontaktstellen erfolgen. Andererseits muß bei Verwendung von federnden Verbindungen an jeder einzelnen Kontaktstelle für ein dynamisches Verhalten der einzelnen gedrückten Kontaktstellen und der Druckkontaktelemente bei von einander unterschiedlicher thermischer und elektrischer Belastung gesorgt werden. Die Alterung der Druckkontaktelemente muß vermieden werden, das wird durch den erfinderischen Aufbau realisiert.

Weiterhin muß der Widerspruch zwischen dem plastischen Verhalten, der wegen seiner elektrischen Isolierfähigkeit aus Kunststoff hergestellten druckgebenden Gehäuse oder Brückenelemente insbesondere bei wechselnder Temperaturbelastung, und der elektrisch leitenden Materialien mit deren elastischen Eigenschaften gelöst werden. Durch die erforderliche Verwendung unterschiedlicher Materialien als Aufbauelemente des drückenden Systems ergeben sich darüber hinaus unterschiedliche Ausdehnungen.

Die Kombination von zwei nach dem Stand der Technik bekannten Werkstoffen (Metall und Kunststoff) erbringt eine zielgerichtete Lösung in der Anwendung zur Herstellung von gekapselten Schaltungsanordnungen. Dabei wird die einfache Kombination und das Verfahren zum Umspritzen von metallischen Materialien in gleicher Weise als Stand der Technik angesehen, denn diese Technologie spiegelt sich verbreitet in vielen Produkten wieder.

Die vorliegende Erfindung setzt Stahl als metallische Komponente ein, der mit Kunststoff umhüllt wird. Die Formgebung des Stahles ist aufgabenbezogen sehr vielfältig. Eine auf das Gehäuse, bzw. das druckgebende Brückenelement, bezogene flächige oder partiell flächige Formgebung mit Durchbrüchen für ein bündiges Umschließen mittels Kunststoff und zur Herstellung von isolierten Durchführungen von elektrischen Verbindungselementen für einen auf der Druckplatte angeordnete Treiber sind stanztechnisch kostengünstig herstellbar und für den Einsatz in Schaltungsanordnungen der Leistungsklasse von großem Vorteil.

Der Stahl kann für seinen erfinderischen Einsatz räumliche Ausformungen erhalten, wodurch sich die flächige Stabilität erhöht und er erhält Noppen und Nasen zur stabilen formschlüssigen Verbindung mit dem Kunststoff. Als Kunststoff haben sich organische Polymere mit einem relativ hohen Anteil von meist anorganischen Füllstoffen in der Praxis bestens bewährt. Dabei wird die Wahl des Kunststoffes neben den wirtschaftlichen Aspekten von dessen elektrischer Isolierfähigkeit und mechanischer Dauerbeständigkeit gegen äußere Einflüsse bestimmt. Der Kunststoff darf in seinen Eigenschaften nur minimale inbesondere druckbedingte Formveränderungen aufweisen.

Durch den Einsatz des erfinderischen Verbundmaterials ist sichergestellt, daß die Druckkontaktierung bei Dauer- oder Wechselbelastung über die gesamte Betriebszeit der Anordnung nicht nennenswert ermüdet. Dabei muß der Stahl in seinem inneren Aufbau so gestaltet sein, daß bei temperaturmäßiger Wechselbelastung die durch Erweichen des Kunststoffes bei höherer Temperatur nachlassenden Druck- bzw. Zugkräfte ausgeglichen werden.

Die temperaturbedingten Biegekräfte sind in engen Toleranzbereichen an allen Druckkontaktstellen mit dem erforderlichen Anpreßdruck bei allen Betriebszuständen so zu gestalten, daß jede einzelne Kontaktstelle sicher kontaktiert wird und nicht durch sich aufbauende überhöhte Druckbelastungen an einzelnen Kontaktstellen eine mechanische Zerstörung des Aufbaus erfolgt. Zum internen Druckausgleich und zur Pufferung der Druckelemente wird ein Kissenelement, wie es nach dem Stand der Technik beschrieben ist, verwendet.

Der Erfindungsgedanke soll nachfolgend in Figuren veranschaulicht werden.
- **Fig. 1**: skizziert einen Querschnitt einer erfinderischen Druckplatte.
- **Fig. 2**: zeigt eine Anwendungsvariante für den Verbundstoff in räumlicher Darstellung.
- **Fig. 3**: stellt einen Aufbauquerschnitt nach Fig. 2 dar.

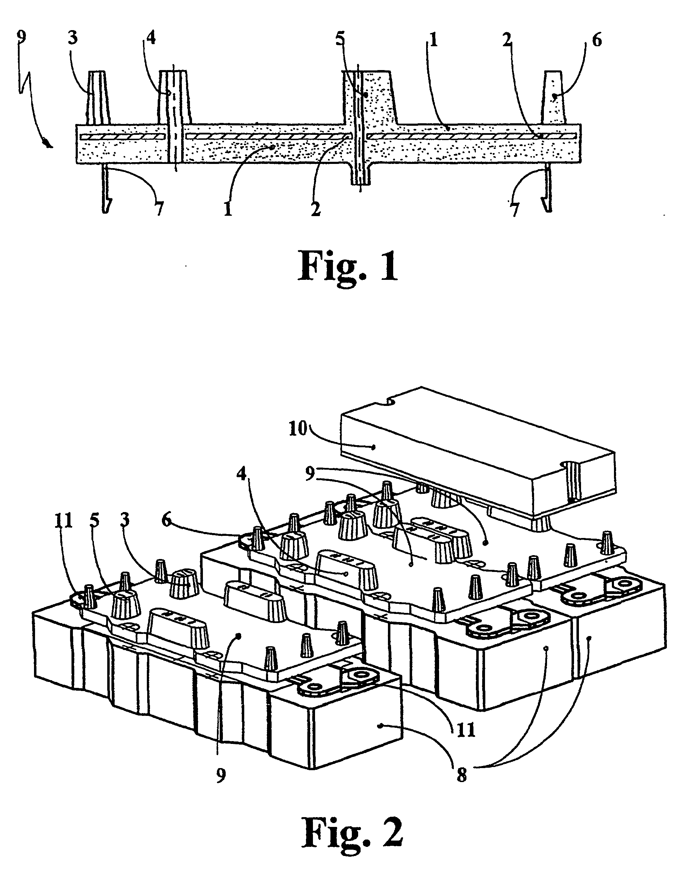

**Fig. 1** skizziert einen Querschnitt einer erfinderischen Druckplatte (9). Ein in der Elektronik bekannter Kunststoff (1) mit den in dieser Branche geforderten Eigenschaften wird in Spritzverfahren zur Ummantelung einer Metallseele (2) herangezogen. Dabei kann der Kunststoff (1) aus verschiedenen organischen Verbindungen mit oder ohne Füllstoff gebildet sein. Als Kunststoff eignen sich hervorragend Polybutylentherephthalat (mit dem Handelsnamen Crastin), Polyphenyläther (mit dem Handelsnamen Noryl), Polyphenylsulfid (mit dem Handelsnamen Ryton) oder Poliamid (mit dem Handelsnamen Ultramid). Der Kunststoff (1) kann an der den Innenaufbauten zugewandten Seite Drucknoppen zur Druckübertragung besitzen.

Der Füllstoff in dem Kunststoff (1) ist abhängig von den gewünschten Eigenschaften nach dem Umspritzen der Metallseele (2). Von 0% bis zu 50% Anteil des Füllstoffes am Gesamtgewicht werden sehr gut reproduzierbare Eigenschaften in der Konstruktion von Gehäuse- oder Brückenelementen für Leistungshalbleiterschaltungsanordnungen erzielt. Ausschlaggebend für die Definition der Mixturen sind die Forderungen nach Form- und Biegefestigkeit, Druckstabilität und Härte.

Die Metallseele (2) wird nach den einzelnen Anwendungsfällen in großer Variationsbreite gefertigt. Allen Ausführungsformen gemeinsam sind solche Oberflächengestaltungen der sonst flächigen Blechform mit Noppen, Wällen oder dreidimensionale Stanzausbuchtungen, die ein zuverlässiges und stabiles Ummanteln mit dem Kunststoff (1) ermöglichen. Die Geometrie der Metallseele kann in zwei Hauptgruppen aufgegliedert werden. Einerseits solche mit ganzflächiger Ausdehnung bezogen auf die Gesamtabmessungen und andererseits mit einer partiellen räumlichen Ausdehnung bezogen auf die Ausdehnungsweite des Kunststoffes. Die sich daraus ergebende Vielfalt kann nicht in allen Varianten dargestellt werden.

Die Metallseele (1) kann aus unterschiedlichen Materialien mit unterschiedlichem thermischen Ausdehnungskoeffizienten gebildet werden. Relativ wirtschaftlich und mit einer erprobten Technologie lieferbar ist Stahl. Sowohl in der Härte als auch in seiner Materialstärke sind gestellte Forderungen reproduzierbar herzustellen. Die reproduzierbare Variationsbreite bietet für alle berechneten Anwendungsbeispiele exakt herstellbare Metallseelen für die Druckstücke oder Gehäusekonstruktionen.

Der Kunststoff (1) erhält erfindungsgemäß mehrere und verschiedenartige Ausbildungen. Durch Hülsen (3) sind spätere Verschraubungen mit darüber plazierten weiteren Schaltungsteilen möglich. Mittels gegenüber der Metalleinlage (2) isolierten Durchführungen (4) können Kontaktstifte isoliert durch die Druckplatte (9) geführt werden. Zu Vergrößerung der Isolierstrecken können beidseitig verlängerte Hülsen (5) aus Kunststoff ausgeprägt sein. In gleicher Weise sind ein- oder beidseitig Noppen (6) aus Kunststoff auszuarbeiten, um beim späteren Montieren definierte geometrische Anordnungen mit einzelnen Druckpunkten zu realisieren. In Erweiterung dessen können Arretierungshaken (7) ausgeformt werden, um eine leichte und geometrisch genaue Positionierung zu realisieren.

**Fig. 2** zeigt eine Anwendungsvariante für den Verbundstoff in räumlicher Darstellung. Es wird das Zusammenwirken der einzelnen Bauteile zu einer funktionsfähigen Einheit skizziert. Dargestellt ist ein dreiphasiger Umrichter in seiner äußeren Gestaltung, bestehend aus drei zueinander paßgerechten Modulen. Der eigentliche Umrichter ist durch ein Gehäuse (8) mechanisch und klimatisch gegen äußere Einflüsse geschützt. Die Versorgungs- bzw. Laststromanschlüsse (11) sind seitlich angeordnet.

Durch die bereits beschriebene Druckplatte (9) werden die Hauptstromanschlüsse (11) auf die Druckkontaktstellen des inneren Umrichteraufbaus gedrückt. Der erforderliche Flächendruck kann bei kleinen Werten durch die Noppen, bei mittlerem und größerem Flächendruck durch Verschraubungen erzeugt werden. Alle übrigen Kontaktanschlüsse für die Ansteuerung und Kontrollmessungen des Umrichters werden durch die bereits beschriebenen Hülsen (3, 4, 5) an die entsprechend ausgebildeten Kontaktierstellen des Umrichters geführt. Auf die Druckplatte (9) kann der Treiber (10) des Umrichter direkt plaziert werden. Die Hülsen (3, 4, 5) und auch Noppen (6) sind dabei für eine genaue Lage und exakte Kontaktierung des Treibers (10) ausgeprägt.

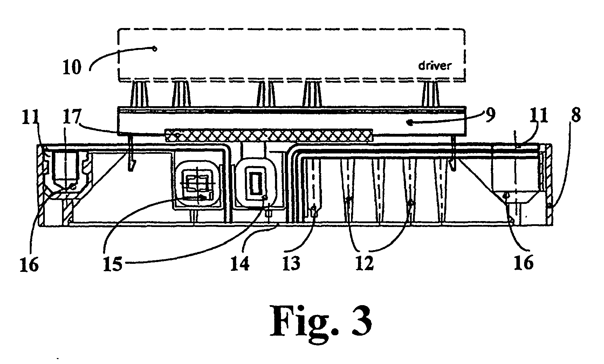

**Fig. 3** stellt einen Aufbauquerschnitt nach Fig. 2 dar. Dargestellt ist das Gehäuse (8) des Umrichters mit entsprechenden Druckelementen (12) und Hülsen (13) für die Durchführung entsprechender Hilfsanschlüsse, jeweils darüber sind die hier nur in ihren Umrissen skizzierten Druckplatte (9) und Treiber (10) positioniert.

Die Schaltungsaufbauten des Umrichters in dem Gehäuse (8) bestehen aus Leistungshalbleiterbauelementen, insbesondere aus Schaltern, wie IGBT oder MOSFET in möglicher teilweiser Parallelschaltung, die in Antiparallelschaltung zusammen mit Freilaufdioden Halbbrücken, Eingangsgleichrichter oder Ausgangsgleichrichter für Leistungsumrichter darstellen können. Die Leistungsbauelemente sind stoffschlüssig durch Löten oder stoffbündig auf den entsprechenden Feldern einer Isolierplatte (14) und untereinander schaltungsgerecht aufgebracht.

Bei der Wahl von geeigneten Keramiken als Isolierplatte (14) ist ein guter Wärmeabtransport auf darunter zu positionierende Kühleinrichtungen möglich. Das Gehäuse bietet in seinem Volumen Platz für Sensoren (15), wie sie für die Erfassung von Betriebsparametern des Umrichters sehr Vorteilhaft eingesetzt werden. Zur Fixierung der Lastanschlüsse und deren Verbindung zu äußeren Kraftstromverbindern sind in dem Gehäuse (8) entsprechende Ausbildungen (16) für das Fixieren von Verschraubungen eingearbeitet.

Zwischen Druckplatte (9) und Gehäuse (8) ist an den Stellen einer dynamischen Druckbelastung ein Druckspeicher (17), beispielhaft in Form eines Silikongummis, positioniert. Die bereits beschriebene Arretierung (7) sorgt für eine exakte Lage der Bauteile zueinander.

## Patentansprüche

1. Umrichter bestehend aus einem Treiber (10), mindestens einem Gehäuse (8) mit aufgesetzter oder integrierter Druckplatte (9) zum Aufbau eines konstanten Drucks sowohl auf ein diesen Druck übertragendes Druckelement (12) zur thermisch leitenden Kontaktierung einer elektrisch isolierenden Grundplatte (14) mit hierauf ausgebildeter Leistungshalbleiterschaltungsanordnung angeordnet auf einen Kühlkörper, sowie auf Stromanschlüsse (11) zu deren elektrisch leitenden Verbindung mit den Kontaktflächen der Grundplatte (14)
**dadurch gekennzeichnet, daß**
die Druckplatte (9) ein Verbundwerkstoff aus einer Metalleinlage (2) mit einer Kunststoffummantelung (1) ist, diese Druckplatte (9) gegenüber der Metalleinlage (2) isolierte Durchführungen (4) aufweist und der Treiber (10) direkt auf der Druckplatte (9) angeordnet ist.

2. UmrichternachAnspruch 1, **dadurch gekennzeichnet, daß**
die Metalleinlage (2) partielle Flächen der flächigen Ausdehnung der Druckplatte (9) ausfüllt und Ausbildungen auf der Oberfläche wie Erhebungen, Noppen, Stege oder Profile und/oder Ausbrüche mit verschiedenen Geometrien aufweist.

3. Umrichter nach Anspruch 1, **dadurch gekennzeichnet, daß**
der Kunststoff (1) ein organisches Polymer ohne Füllstoff oder mit anorganischen Füllstoffen bis zu 50% der Gesamtmasse ist.

4. UmrichternachAnspruch3, **dadurch gekennzeichnet, daß**
der Kunststoff (1) Polybutylentherephthalat, Polyphenyläther, Polyphenylsulfid oder Polyamid ist.

5. Umrichter nach Anspruch 2, **dadurch gekennzeichnet, daß**
die Metalleinlage (2) eine Stahllegierung ist.

## Claims

1. A converter consisting of a driver (10), at least one housing (8) comprising an attached or integrated pressure plate (9) for building up a constant pressure as well as a pressure element (12) transmitting said pressure for thermally conductively contacting an electrically insulating base plate (14) comprising power semiconductor circuit configurations embodied thereon disposed on a cooling body, as well as bus bars (11) for an electrically conductive connection with the contact surfaces of the base plate (14)
**characterized in that**
the pressure plate (9) is a composite material consisting of a metal insert (2) comprising a plastic casing (1), said pressure plate (9) encompassing lead-throughs (4) insulated against the metal insert (2) and the driver (10) being disposed directly on the pressure plate (9).

2. The converter according to claim 1,
**characterized in that**
the metal insert (2) fills partial surfaces of the flat expansion of the pressure plate (9) and encompasses formations on the surface area, such as elevations, ridges, bars or profiles and/or nicks comprising different geometries.

3. The converter according to claim 1,
**characterized in that**
the plastic (1) is an organic polymer without filler material or with inorganic filler material of up to 50 % of the total volume.

4. The converter according to claim 3,
**characterized in that**
the plastic (1) is polybutylene terephthalat, polyphenyl ether, polyphenyl sulfide or polyamide.

5. The converter according to claim 2,
**characterized in that**
the metal insert (2) is a steel alloy.

## Revendications

1. Convertisseur constitué d'un driver (10), d'au moins un boîtier (8) à plaque de pression (9) rapportée ou intégrée pour l'exercice d'une pression constante, aussi bien sur un élément de pression (12) transmettant cette pression pour l'établissement de contact thermiquement conducteur d'une plaque de base (14) électriquement isolante, sur laquelle un montage à semi-conducteurs de puissance est agencé sur un corps de refroidissement, que sur des raccordements de courant (11) pour leur liaison électriquement conductrice avec les surfaces de contact de la plaque de base (14),
**caractérisé en ce que**
la plaque de pression (9) est un matériau composite en un insert métallique (2) avec un enrobage en matière plastique (1), cette plaque de pression (9) comporte des passages (4) isolés par rapport à l'insert métallique (2), et le driver (10) est disposé directement sur la plaque de pression (9).

2. Convertisseur selon la revendication 1, **caractérisé en ce que** l'insert métallique (2) remplit des surfaces partielles de l'extension superficielle de la plaque de pression (9), et comporte des conformations en surface, telles que des surélévations, des ergots, des nervures ou des profils, et/ou des percées de différentes géométries.

3. Convertisseur selon la revendication 1, **caractérisé en ce que** la matière plastique (1) est un polymère organique sans matière de charge, ou avec des matières de charge inorganiques allant jusqu'à 50 % de la masse totale.

4. Convertisseur selon la revendication 3, **caractérisé en ce que** la matière plastique (1) est du polybutènetéréphtalate, de l'éther de polyphényle, du polyphényle sulfure ou du polyamide.

5. Convertisseur selon la revendication 2, **caractérisé en ce que** l'insert métallique (2) est un alliage d'acier.
